# EUROPÄISCHE PATENTSCHRIFT

(11) **EP 1 807 871 B1**
(45) Veröffentlichungstag und Bekanntmachung des Hinweises auf die Patenterteilung: **08.10.2008**
(21) Anmeldenummer: 05821947.8
(22) Anmeldetag: 07.11.2005
(51) Int. Cl.: H01L 31/0224

(54) **VERFAHREN ZUR HERSTELLUNG EINER BEIDSEITIG LICHTEMPFINDLICHEN SOLARZELLE UND BEIDSEITIG LICHTEMPFINDLICHE SOLARZELLE**
METHOD FOR PRODUCING A TWO-SIDE LIGHT-SENSITIVE SOLAR CELL AND DOUBLE-SIDED LIGHT-SENSITIVE SOLAR CELL
PROCEDE DE PRODUCTION D'UNE CELLULE SOLAIRE SENSIBLE A LA LUMIERE DES DEUX COTES, ET CELLULE SOLAIRE SENSIBLE A LA LUMIERE DES DEUX COTES

(30) Priorität: 07.11.2004 DE 102004053873
(43) Veröffentlichungstag der Anmeldung: 18.07.2007
(73) Patentinhaber: Institut für Solarenergieforschung GmbH, 31860 Emmerthal (DE)
(72) Erfinder: TEPPE, Andreas, 63755 Alzenau (DE); MEYER, Rüdiger, 31812 Bad Pyrmont (DE); ENGELHART, Peter, 31785 Hameln (DE)
(74) Vertreter: Maiwald Patentanwalts GmbH
(86) Internationale Anmeldenummer: PCT/EP2005/011883
(87) Internationale Veröffentlichungsnummer: WO 2006/048319

(56) Entgegenhaltungen:
- EP-A- 1 378 946
- DE-A1- 10 142 481

## Beschreibung

Die vorliegende Erfindung betrifft eine beidseitig lichtempfindliche Solarzelle, bei der sowohl der Emitterkontakt als auch der Basiskontakt an einer Rückseite eines Halbleitersubstrates angeordnet sind sowie ein Verfahren zu deren Herstellung.

### Hintergrund der Erfindung

Solarzellen dienen dazu, Licht in elektrische Energie umzuwandeln. Dabei werden in einem Halbleitersubstrat durch Licht erzeugte Ladungsträgerpaare durch einen pn-Übergang getrennt und dann über den Emitterkontakt und den Basiskontakt einem einen Verbraucher aufweisenden Stromkreis zugeführt.

### Stand der Technik

Die überwiegende Zahl der derzeit eingesetzten Solarzellen besteht gewöhnlich aus einem Halbleiterkörper eines Leitungstyps (z. B. p-leitend), in dem an der Oberfläche ein Gebiet des entgegen gesetzten Leitungstyps (z. B. n-leitend) erzeugt wird, und auf beiden Seiten des Halbleiterkörpers elektrische Kontakte angebracht sind. Die durch das einfallende Licht erzeugten Elektron-Loch-Paare (Minoritäts- und Majoritätsladungsträger) werden im elektrischen Feld des pn-Übergangs getrennt, die Elektronen wandern zum n-Gebiet, die Löcher zum p-Gebiet, wo sie jeweils über Metallkontakte abfließen. Auf der Vorderseite sind diese Metallkontakte in Gitterform ausgeführt, um den Lichteinfall zu ermöglichen.

Um die Lichtabschattung durch diese in Streifenform ausgeführten Metallfinger weitgehend zu eliminieren und die Verbindung der Solarzelle im Solarmodul wirtschaftlicher zu gestalten, ist es bekannt, beide elektrische Kontakte auf der Rückseite des Halbleiterkörpers anzubringen und somit beide Ladungsträgerarten an der dem Licht abgewandten Seite zu sammeln (US 4,315,097). Die bisherigen rückseitig sammelnden Solarzellen sind so gestaltet, dass die Minoritätsladungsträger nicht, wie bei den normalen Zellen auf der Vorderseite, lateral durch eine dünne n⁺-Schicht im Fallbeispiel eines p-Halbleiters zu den Kontakten fließen müssen. Aus diesem Grunde sowie auch wegen der äußerst komplexen Technologie werden diese so genannten IBC (Interdigitated Back Contact) Solarzellen hauptsächlich für hoch konzentriertes Licht, also für sehr hohe Stromdichten verwendet (M. D. Lammert, R. J. Schwartz, "The Interdigitated Back Contact Solar Cell. A Silicon Solar Cell for Use in Concentrated Sunlight", IEEE Transactions on Electron Devices, Vol. ED-24, No. 4, S. 337 - 342 (1977)).

Der IBC Zelle sehr ähnlich ist die Punktkontakt (PC)-Solarzelle (R. M. Swanson, Solar Cells, Vol. 17, No. 1, S. 85 - 118 (1986)). Bei dieser werden die beiden Kontaktgebiete, metallisierte n⁺ und p⁺ Bereiche, auf der Rückseite in Form von Punkten sehr klein gehalten, um den Sättigungssperrstrom zu erniedrigen und damit die Leerlaufspannung der Zelle zu erhöhen. Extrem gute Oberflächenpassivierung z. B. durch thermisches Siliziumoxid spielt dabei eine entscheidende Rolle.

Für die oben aufgeführten Solarzellen sind äußerst aufwendige Hochtemperaturprozesse einschließlich feinster Strukturierung durch Photolackmasken- und Ätzprozesse erforderlich, so dass eine großflächige terrestrische Anwendung ohne Konzentration des Lichtes äußerst unwirtschaftlich wäre.

Eine andere Solarzelle mit beiden Kontakten auf einer Seite des Halbleiterkörpers wird in der DE 41 43 083 A1 beschrieben. Dabei sind die ersten und zweiten Kontakte horizontal und in unterschiedlichen Ebenen auf einer Erhebungen aufweisenden Halbleitersubstratfläche angeordnet. Die Breite der Majoritätsträgersammelkontakte ist durch die Breite der Erhebungen vorgegeben, wie auch die Fläche der Minoritätsträgerkontakte. Diese Struktur weist jedoch hinsichtlich ihrer elektronischen Eigenschaften den Nachteil auf, dass durch die Beschränkung der Breite der Majoritätsträgerkontakte auf die Fläche des nicht diffundierten Basisgebietes dieses größer als notwendig ausgeführt werden muss, um die elektrischen Verluste in den Basiskontakten gering zu halten. Hierdurch ergibt sich ein hoher Sättigungssperrstrom und somit eine verminderte Leerlaufspannung der Solarzelle.

Eine weiter entwickelte vollständig rückseitig kontaktierte Solarzelle wird in DE 101 42 481 A1 beschrieben und mit der Bezeichnung Back OECO Solarzelle oder Rear OECO Solarzelle betitelt. Diese Zelle basiert auf einer mechanisch mittels Schleifverfahren strukturierten rückseitigen Fläche des Halbleiterkörpers. Auf die senkrecht oder nahezu senkrecht zur ursprünglichen Oberfläche verlaufenden Flanken der auf diese Weise erzeugten parallelen geraden Stege der Rückseitenstruktur werden die Minoritäts- und die Majoritätsträgerkontakte aufgebracht. Dabei befindet sich auf jeweils einer der beiden Flanken eines Steges ein Majoritätsträgerkontaktfinger und parallel dazu auf der gegenüberliegenden Flanke des selben Steges ein Minoritätsträgerkontaktfinger. In einem ersten selbst justierenden Vakuumaufdampfschritt wird hierzu der erste elektrische Kontakt hergestellt, in einem zweiten, nachfolgenden Vakuumaufdampfschritt wird der zweite elektrische Kontakt erzeugt.

Die beschriebene Zellstruktur weist folgende Nachteile auf, die sowohl die elektronischen Eigenschaften und damit den erzielbaren Wirkungsgrad beeinflussen, als auch technologischer Natur sind.
i) Eine nur schwer überwindbare Einschränkung im Hinblick auf die elektronischen Eigenschaften der Zelle ist die Tatsache, dass infolge des beschriebenen Verfahrens zur Herstellung der beiden Kontakte der Solarzelle eine immer gleiche oder nahezu gleiche Anzahl von Majoritäts- und Minoritätsträgerträgerkontaktlinien vorhanden ist. Dabei folgt immer eine Majoritätsträgerkontaktlinie auf eine Minoritätsträgerkontaktlinie, wobei deren Abstand auf der einen Seite durch den Abstand der Erhebungen der rückseitigen Oberflächenstruktur des Halbleiterkörpers sowie die Tiefe der Gräben im Halbleiterkörper definiert ist. Auf der zweiten Seite ist der Abstand der beiden unterschiedlichen Kontaktlinien durch die Breite der Spitzen bzw. Plateaus der Erhebungen festgelegt. Diese beiden Abstände sind typischerweise nicht gleich, sondern weichen erheblich voneinander ab, so dass es zu einer stark unsymmetrischen Anordnung der Minoritätsträgerkontaktlinien auf dem Emittergebiet der Solarzelle kommt. Infolge des endlichen Schichtwiderstandes des Emitters verlangt dies entweder eine zu hohe Dotierung des Emitters, was sich negativ auf den Sättigungssperrstrom und damit auf die Spannung der Solarzelle auswirkt, oder es treten im Emittergebiet elektrische Serienwiderstandsverluste auf, die eine Verringerung des Füllfaktors zur Folge haben.
ii) Ein weiterer Nachteil der beschriebenen Anordnung der Kontaktlinien ist, dass durch die hohe Anzahl von Basiskontaktlinien auch ein unnötig großer Flächenanteil der Solarzellenrückseite als Basisgebiet ausgeführt werden muss. Hierdurch verringert sich entsprechend der Flächenanteil des Emittergebietes, was zu einer Einschränkung der Fähigkeit der Solarzelle führt, die generierten Minoritätsladungsträger im Emitter zu sammeln. Infolge dessen ist die erreichbare Stromdichte der Solarzelle eingeschränkt.
iii) Die mechanische Oberflächenstrukturierung des Halbleiterkörpers ist verbunden mit einer starken mechanischen Beanspruchung des typischerweise spröden Halbleitermaterials. Dies führt zu einer erhöhten Bruchanfälligkeit des Halbleiterkörpers während des Herstellungsprozesses der Solarzelle sowie der fertig gestellten Solarzelle im Solarmodul.
iv) Zur Herstellung der Kontakte werden zwei aufeinander folgende Vakuumaufdampfschritte eingesetzt. Dieses Verfahren ist trotz des hohen erzielbaren Durchsatzes ein für die Massenfertigung teurer Prozess.
v) Um die Back OECO Solarzellen im Modul elektrisch miteinander verbinden zu können, ist eine Abfolge komplizierter Prozessschritte zur lokalen Isolation der beiden Kontaktfingerarten (Minoritätsträger- und Majoritätsträgerkontaktfinger) voneinander notwendig, um die elektrischen Zellverbinder aufbringen zu können. Dieses Verfahren führt zu einem komplizierten und teuren Herstellungsprozess.

### Aufgabe der Erfindung

Die vorliegende Erfindung soll die oben geschilderten Nachteile der Back OECO Solarzelle vermeiden. Insbesondere soll es möglich sein, die Anordnung der ersten und zweiten elektrischen Kontakte der Solarzelle in ihrer Abfolge und ihrem Abstand mit großer Freiheit wählen zu können. Dabei soll die Herstellung der rückseitigen Oberflächenstruktur durch ein einfacheres Herstellverfahren ersetzt und so die Verschaltung der Solarzelle im Modul vereinfacht werden. Aufgrund der vorliegenden Erfindung soll es damit ermöglicht werden, Solarzellen mit verbessertem Wirkungsgrad sowie einfachen und damit kostengünstigen Methoden herzustellen.

### Beschreibung der Erfindung

Die Erfindung bezieht sich auf eine Solarzelle (10) umfassend ein Halbleitersubstrat (11) mit ersten und zweiten Kontakten (22, 23) zum Sammeln und Ableiten von durch einfallende Strahlungsenergie in dem Halbleitersubstrat erzeugten Minoritäts- und Majoritätsladungsträgern, wobei die rückseitige Fläche (13) des Halbleitersubstrats zumindest bereichsweise linien- bzw. stegartige Erhebungen (14) und erste und zweite linien- bzw. bandförmige Vertiefungen (15, 16) mit jeweils erster und zweiter Längswand (18, 19, 20, 21) aufweisen, und wobei die ersten und zweiten elektrischen Kontakte auf der rückseitigen Fläche des Halbleitersubstrats beabstandet zueinander angeordnet sind. Ferner nimmt die Erfindung Bezug auf ein Verfahren zur Herstellung einer Solarzelle umfassend ein Halbleitersubstrat, in welchem durch einfallende Strahlungsenergie Minoritäts- und Majoritätsladungsträger erzeugt werden, die über erste und zweite streifen- oder bandförmige erste und zweite Längswände aufweisende Vertiefungen aufweisender rückseitiger Fläche des Halbleitersubstrats verlaufende erste und zweite elektrische Kontakte gesammelt und abgeleitet werden, wobei die ersten und zweiten elektrischen Kontakte unmittelbar auf der rückseitigen Fläche aufgebracht werden oder die ersten und zweiten elektrischen Kontakte nach ganzflächigem oder weitgehend ganzflächigem Abdecken der rückseitigen Fläche mit einer Passivierungsschicht (27) und / oder einer diffusionsverhindernden Schicht (25) und gegebenenfalls Entfernen von Bereichen der Passivierungsschicht teilweise oder vollständig auf so freigelegte Bereiche des Halbleitersubstrats aufgebracht werden.

Erfindungsgemäß wird das Problem im Wesentlichen durch eine Solarzelle der eingangs genannten Art dadurch gelöst, dass sich in zumindest einigen der Vertiefungen, vorzugsweise in allen oder nahezu allen Vertiefungen, die ersten elektrischen Kontakte (22) auf den ersten Längswänden (18) erster Vertiefungen (15) und die zweiten elektrischen Kontakte (23) auf den ersten Längswänden (19) zweiter Vertiefungen (16) erstrecken, dass auf die jeweils zweiten Längswände (20, 21) der ersten und zweiten Vertiefungen (15, 16) keine elektrischen Kontakte aufgebracht werden und dass die Aufbringung der elektrischen Kontakte gleichzeitig in einem Herstellungsprozessschritt und nicht in zwei aufeinander folgenden Herstellungsprozessschritten erfolgt.

Die erfindungsgemäße Lehre wird durch ein System von auf den Längswänden der rückseitig verlaufenden Vertiefungen angeordneten Kontakten realisiert, die auch als Emitterkontakte für das Sammeln der Minoritätsladungsträger und als Basiskontakte für das Sammeln der Majoritätsladungsträger bezeichnet werden können. Die Verwirklichung der Anordnung der Kontakte auf den Längswänden der auf der rückseitigen Fläche des Halbleiterkörpers sich erstreckenden linien- oder bandförmigen Vertiefungen ist dabei nicht auf einen bestimmten Solarzellentyp wie z. B. Wafer-basierte Siliciumsolarzellen begrenzt.

Das durch eine rückseitige Doppel-Kontaktgitterstruktur einfallende Licht kann zusätzlich genutzt werden (Bifacial-Solarzelle). Auf diese Weise wird eine einfache von jeder Seite allein oder von beiden Seiten beleuchtbare und damit von jeder Seite einseitig oder von beiden Seiten Minoritätsladungsträger sammelnde Solarzelle zur Verfügung gestellt.

Erfindungsgemäß ist vorgesehen, dass die rückseitigen linien- oder bandförmigen Vertiefungen unter Anwendung eines Ätzverfahrens hergestellt werden soll. Der Halbleiterkörper soll dabei typischerweise vorher vollständig mit einer reflexionsvermindernden Oberflächenstruktur versehen werden. Die Herstellung der reflexionsvermindernden Oberflächenstruktur kann jedoch auch unterlassen werden. Zur Herstellung der rückseitigen linien- oder bandförmigen Vertiefungen wird der Halbleiterkörper erfindungsgemäß vollständig oder teilweise mit einer ätzresistenten Oberflächenschicht versehen. Diese Oberflächenschicht wird erfindungsgemäß mit Hilfe geeigneter Verfahren lokal wieder entfernt. Dabei sollen vorzugsweise Verfahren der Laser-Materialbearbeitung oder der Materialbearbeitung mittels Wasserstrahltechnik oder Kombinationen aus beiden Verfahren eingesetzt werden. Es sollen aber auch andersgeartete Materialbearbeitungsverfahren eingesetzt werden können. Während des lokalen Entfernens der ätzresistenten Oberflächenschicht soll der Halbleiterkörper typischerweise nicht angegriffen werden. Es soll aber auch möglich sein, zusammen mit der ätzresistenten Oberflächenschicht einen Teil des unmittelbar darunter angrenzenden Halbleiterkörpers zu entfernen.

Die Umrisse der verbleibenden ätzresistenten Oberflächenschicht auf der mit einer Oberflächenstruktur zu versehenden Seite des Halbleiterkörpers soll typischerweise den Umrissen ähnlich sein, welche die erhabenen Flächen der späteren Oberflächenstruktur aufweisen sollen. Dabei sind der Ausgestaltung der Umrisse der verbleibenden ätzresistenten Oberflächenschicht keine Grenzen gesetzt. Erfindungsgemäß sollen jedoch die von der ätzresistenten Oberflächenschicht befreiten Flächenanteile des Halbleiterkörpers die Gestalt verschiedener oder gleichartiger linearer oder nahezu linearer Bänder haben. Die Breite der ersten und der zweiten Bänder kann immer gleich sein, typischerweise sollen die ersten Bänder eine unterschiedlich Breite aufwiesen als die zweiten Bänder. Die Breite der ersten und der zweiten Bänder soll erfindungsgemäß dem Abstand, welchen die einzelnen erhabenen Bereiche der zu erzeugenden Oberflächenstruktur des Halbleiterkörpers im weiteren Verlauf des Prozesses annehmen sollen, ähnlich sein. Dabei sollen erfindungsgemäß ein oder mehrere erste Bänder auf ein oder mehrere zweite Bänder folgen und umgekehrt. Die ersten Bänder sollen in ihrer Längsrichtung gegenüber den zweiten Bändern um einigen Abstand versetzt sein. Dabei sollen erste und zweiter Bänder typischerweise gleich lang sein, können aber auch unterschiedliche Längen aufweisen.

Nachdem die ätzresistente Oberflächenschicht auf die beschriebene Weise strukturiert worden ist, soll mit Hilfe bekannter Verfahren der Halbleiterkörper an den nicht mehr durch die ätzresistente Oberflächenschicht bedeckten Bereichen abgetragen werden. Dabei soll der Materialabtrag vorzugsweise in inverser Richtung der Flächennormalen der mit einer Oberflächenstruktur zu versehenden Fläche des Halbleiterkörpers stattfinden. Der Materialabtrag soll dabei erfindungsgemäß so weit durchgeführt werden, dass die entstehenden Vertiefungen in dem Halbleiterkörper eine Tiefe von bis zu mehreren 10 Mikrometern erreicht haben, sie können jedoch auch flacher ausgeführt werden.

Erfindungsgemäß soll das Verfahren zur lokalen Entfernung des Halbleiterkörpers so ausgeführt werden, dass die entstehenden Flanken der Oberflächenstruktur senkrecht oder nahezu senkrecht ausgebildet werden. Sie können jedoch auch geneigt sein. Die Grabensohlen der entstehenden Oberflächenstruktur des Halbleiterkörpers sollen typischerweise mit einer reflexionsvermindernden Struktur z. B. in Form von mikroskopischen Pyramiden versehen sein. Sie können jedoch auch glatt oder anderweitig geformt ausgebildet sein.

Die Aufbringung der elektrischen Kontakte soll unter Anwendung des Schrägaufdampfverfahrens erfolgen. Dabei sollen sowohl die ersten als auch die zweiten elektrischen Kontakte im Zuge desselben Schrägaufdampfprozesses aufgebracht werden. Die elektrischen Kontakte sollen sich dabei auf den Längswänden der bandförmigen Vertiefungen niederschlagen.

Als Diffusionsbarriere für die Fläche des Basiskontaktes und dessen Umgebung soll lokal (z. B. mit Dispenser-Technik) ein Mittel (z. B. eine Paste oder eine Flüssigkeit) aufgebracht werden, welche durch Wärmezufuhr trocknet und aushärtet. Dieses Mittel soll erfindungsgemäß auf der Zelle erhalten bleiben, und der Basiskontakt soll durch gezielte Energiezufuhr (z. B. durch Laserstrahlen) durch diesen Film durchgefeuert werden.

Eine weitere Methode zur lokalen Definition der Diffusionsbarriere für das Gebiet des Basiskontaktes ist das ganzflächige Aufbringen des Mittels und die lokale Erwärmung und Aushärtung des Mittels durch Laserstrahlen. Der nicht erhitzte Anteil des Mittels kann dann leicht wieder abgespült werden.

Erfindungsgemäß kann das als Diffusionsbarriere verwendete Mittel einen Stoff (z. B. Bor im Falle eines p-Halbleiters) enthalten, welcher zur Dotierung des Halbleiters geeignet ist. In nachfolgenden Hochtemperaturprozessen kann dieser Dotierstoff dann aus diesem Mittel in den Halbleiter diffundieren und so ein lokales n⁺- oder p⁺-Gebiet erzeugen.

Die Passivierung der rückseitigen Oberfläche des Halbleiterkörpers, d. h. die elektronische Vergütung der Halbleiteroberfläche durch eine Passivierschicht oder ein Passivierschichtsystem, kann vor oder auch nach Aufbringung der ersten und zweiten elektrischen Kontakte erfolgen. Wird die Passivierung vor Aufbringung der elektrischen Kontakte durchgeführt, kann die Passivierschicht an den Flächen, wo der Emitterkontakt entstehen soll, lokal z. B. mittels Laserstrahlung entfernt werden.

Die elektrische Verbindung der ersten elektrischen Kontakte untereinander sowie der zweiten elektrischen Kontakte untereinander soll erfindungsgemäß mittels elektrisch leitfähiger Materialien (z. B. elektrisch leitfähige Pasten oder elektrisch leitfähige Klebstoffe) durchgeführt werden. Dafür werden diese elektrisch leitfähigen Materialien dort, wo die ersten bandförmigen Vertiefungen enden und wo aufgrund der Verschiebung der ersten bandförmigen Vertiefungen in Längsrichtung keine zweiten bandförmigen Vertiefungen mehr zwischen den ersten bandförmigen Vertiefungen verlaufen, auf die rückseitige Halbleiteroberfläche aufgebracht und sollen somit eine durchgängige elektrische Verbindung zwischen den ersten elektrischen Kontakten herstellen. Ebenso soll mit den zweiten elektrischen Kontakten verfahren werden. Erfindungsgemäß sollen diese Verbindungsstrecken der ersten und zweiten elektrischen Kontakte zur Aufbringung der elektrischen Zellverbinder im Modul genutzt werden.

Weitere Einzelheiten, Vorteile und Merkmale der vorliegenden Erfindung ergeben sich aus den Ansprüchen, den diesen zu entnehmenden Merkmalen für sich und/oder in Kombination, sowie auch aus Zeichnungen 1 bis 4.

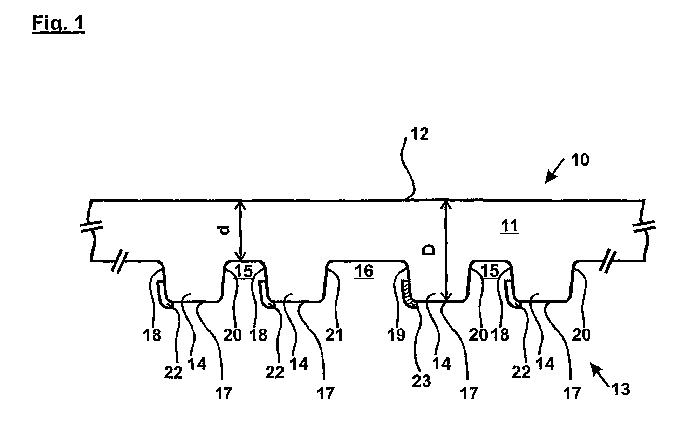

Es zeigen
Fig. 1 die Prinzipdarstellung einer Solarzelle (12) mit ausschließlich auf der Rückseite (13) angeordneten ersten und zweiten Kontakten (22, 23). Die Kontakte befinden sich an den ersten Wänden (18, 19) der ersten und zweiten rinnenförmigen Vertiefungen (15, 16).

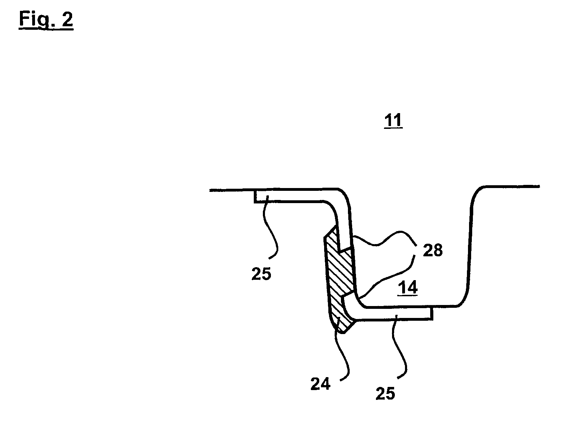

Fig. 2 im Detail die Anordnung des Basiskontaktes (24), der zu einem großen Teil auf der vorher aufgebrachten Diffusionsbarriere (25) verläuft und im Herstellungsprozess lokal durch diese hindurchgefeuert wurde. Der Verlauf der Diffusionsbarriere (25) beschränkt sich dabei nicht auf die reine Fläche (28) des elektrischen Kontaktes (24).

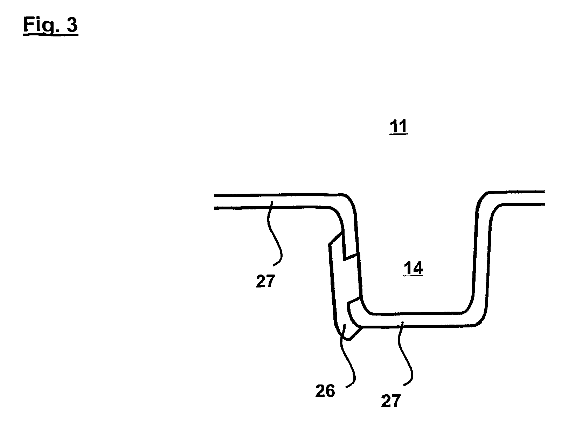

Fig. 3 im Detail die Anordnung des Emitterkontaktes (26), der in der gezeigten Ausführungsform zu einem großen Teil auf der zuvor aufgebrachten Passivierschicht (27) verläuft, welche im Herstellungsprozess lokal im Bereich des Emitterkontaktes (26) entfernt worden ist.

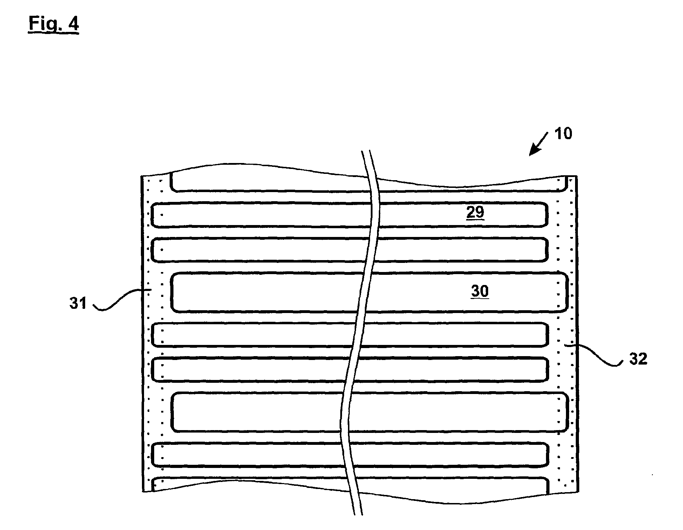

Fig. 4 eine Draufsicht eines Ausschnittes der rückseitigen Oberfläche einer Solarzelle (10) mit einer Prinzipdarstellung des Verlaufes der ersten und zweiten rinnenförmigen Vertiefungen (29, 30). In der Region (31), wo die Abfolge der ersten rinnenförmigen Vertiefungen (29) durch den seitlichen Versatz gegenüber den zweiten rinnenförmigen Vertiefungen (30) nicht von diesen zweiten rinnenförmigen Vertiefungen unterbrochen wird, soll das Material zur Verbindung der ersten elektrischen Kontakte aufgebracht werden. In der Region (32), wo die Abfolge der zweiten rinnenförmigen Vertiefungen (30) durch den seitlichen Versatz gegenüber den ersten rinnenförmigen Vertiefungen (29) nicht von diesen ersten rinnenförmigen Vertiefungen unterbrochen wird, soll das Material zur Verbindung der zweiten elektrischen Kontakte aufgebracht werden.

## Patentansprüche

1. Verfahren zur Herstellung einer Solarzelle (10) umfassend ein Halbleitersubstrat (11), in welchem durch einfallende Strahlungsenergie Minoritäts- und Majoritätsladungsträger erzeugt werden und welches rückseitig erste und zweite vertiefte linien- oder band förmige Strukturen (15, 16) mit jeweils ersten und zweiten steilen Längswänden (18, 19, 20, 21) aufweist, wobei die ersten Längswände (18) der ersten linien- oder bandförmigen Vertiefungen (15) eine ähnlich oder gleiche Richtung der Flächennormalen und damit eine ähnliche oder gleiche Orientierung aufweisen wie die ersten Längswände (19) der zweiten linien- oder bandförmigen Vertiefungen (16) und die zweiten Längswände (20) der ersten linien- oder bandförmigen Vertiefungen (15) eine ähnlich oder gleiche Richtung der Flächennormalen und damit eine ähnliche oder gleiche Orientierung aufweisen wie die zweiten Längswände (21) der zweiten linien- oder bandförmigen Vertiefungen (16), **dadurch gekennzeichnet, dass** zumindest auf einige oder alle erste Längswände (18) der ersten vertieften linien- oder bandförmigen Strukturen (15) erste elektrische Kontakte (22, 26) zum Sammeln und Ableiten eines Ladungsträgertyps (also z. B. der Minoritätsladungsträger) und gleichzeitig zumindest auf einige oder alle erste Längswände (19) der zweiten vertieften linien- oder bandförmigen Strukturen (16) zweite elektrische Kontakte (23, 24) zum Sammeln und Ableiten des anderen Ladungsträgertyps (also z. B. der Majoritätsladungsträger) aufgebracht werden und dass auf die jeweils zweiten Längswände (20, 21) der ersten und zweiten vertieften linien- oder bandförmigen Strukturen (15, 16) keine Kontakte aufgebracht werden.

2. Verfahren nach Anspruch 1, **dadurch gekennzeichnet, dass** die ersten und die zweiten linien- oder bandförmigen Vertiefungen mittels eines Verfahrens zum Abtrag des Halbleitermaterials erzeugt werden, bei dem sich die Bereiche des Halbleitersubstrates, welche nicht abgetragen werden sollen, unter Verwendung einer Oberflächenschicht, die gegen das Verfahren des Abtrages des Halbleitermaterials resistent ist, geschützt werden.

3. Verfahren nach Anspruch 1 oder 2, **dadurch gekennzeichnet, dass** die ersten und zweiten Kontakte gleichzeitig durch Aufdampfen von Material unter einem Winkel α zur von dem Halbleitersubstrat aufgespannten Ebene aufgebracht werden, wobei der Aufdampfwinkel α beträgt α ≠0° und α ≠90°.

4. Verfahren nach zumindest einem der vorhergehenden Ansprüche, **dadurch gekennzeichnet, dass** die rückseitige Fläche des Halbleitersubstrates zumindest teilweise oder ganz mit einer Oberflächenschicht versehen wird, welche das Eindiffundieren von Fremdstoffen verhindert.

5. Verfahren nach Anspruch 4, **dadurch gekennzeichnet, dass** die Oberflächenschicht, welche das Eindiffundieren von Fremdstoffen verhindert, selbst Quelle eines Fremdstoffes ist, welcher zur Dotierung des Halbleitersubstrates geeignet ist.

6. Verfahren nach Anspruch 4 oder 5, **dadurch gekennzeichnet, dass** die Oberflächenschicht, welche das Eindiffundieren von Fremdstoffen verhindert, durch geeignete Prozesse, z. B. Laserstrahlung, lokal erwärmt wird, so dass sich ihre physikalischen und / oder chemischen Eigenschaften gegenüber den nicht erwärmten Bereichen ändern.

7. Verfahren nach zumindest einem der Ansprüche 4, 5 und 6, **dadurch gekennzeichnet, dass** die ersten oder zweiten elektrischen Kontakte vollständig auf der Oberflächenschicht, welche das Eindiffundieren von Fremdstoffen verhindert, verlaufen und dass diese ersten oder zweiten elektrischen Kontakte diese Oberflächenschicht durch lokales Erwärmen, z. B. durch Laserstrahlung, durchdringen.

8. Verfahren nach zumindest einem der vorhergehenden Ansprüche, **dadurch gekennzeichnet, dass** vor oder nach dem Aufbringen der ersten und zweiten elektrischen Kontakte die freiliegenden Oberflächen des Halbleitersubstrates und alle weiteren exponierten Flächen ganzflächig oder weitgehend ganzflächig mit einer Schicht oder einem Schichtsystem versehen werden, welches geeignet ist, die Halbleiteroberfläche elektronisch zu vergüten.

9. Verfahren nach Anspruch 8 **dadurch gekennzeichnet, dass** die passivierende Oberflächenschicht vor Aufbringen der ersten und zweiten elektrischen Kontakte hergestellt wird und dort, wo der zweite oder erste elektrische Kontakt aufgebracht werden soll, vollständig oder zumindest teilweise mittels geeigneter Verfahren, z. B. Laserstrahlung, wieder entfernt wird.

10. Verfahren nach zumindest einem der vorgenannten Ansprüche, **dadurch gekennzeichnet, dass** die ersten linien- oder bandförmigen Vertiefungen gegenüber den zweiten linien- oder bandförmigen Vertiefungen in deren Längsrichtung um einigen Abstand seitlich versetzt angeordnet werden.

11. Verfahren nach Anspruch 10, **dadurch gekennzeichnet, dass** die ersten elektrischen Kontakte, welche sich an den ersten oder zweiten Wänden der ersten linien- oder bandförmigen Vertiefungen befinden, in der Region, wo die ersten linien- oder bandförmigen Vertiefungen durch den seitlichen Versatz über die zweiten linien- oder bandförmigen Vertiefungen hinausragen, mittels eines geeigneten elektrisch leitfähigen Materials elektrisch miteinander verbunden werden, und die zweiten elektrischen Kontakte, welche sich an den ersten oder zweiten Wänden der zweiten linien- oder bandförmigen Vertiefungen befinden, in der Region, wo die zweiten linien- oder bandförmigen Vertiefungen durch den seitlichen Versatz über die ersten linien- oder bandförmigen Vertiefungen hinausragen, mittels eines geeigneten elektrisch leitfähigen Materials elektrisch miteinander verbunden werden.

12. Solarzelle (10) umfassend ein Halbleitersubstrat (11), in welchem durch einfallende Strahlungsenergie Minoritäts- und Majoritätsladungsträger erzeugt werden und welches rückseitig erste und zweite vertiefte linien- oder bandförmige Strukturen (15, 16) mit jeweils ersten und zweiten steilen Längswänden (18, 19, 20, 21) aufweist, wobei die ersten steilen Längswände (18) der ersten vertieften linien- oder bandförmigen Strukturen (15) die gleiche oder annähernd gleiche Richtung der Flächennormalen und damit eine gleiche oder annähernd gleiche Orientierung aufweisen wie die ersten steilen Längswände (19) der zweiten vertieften linien- oder bandförmigen Strukturen (16) und die zweiten steilen Längswände (20) der ersten vertieften linien- oder bandförmigen Strukturen (15) die gleiche oder annähernd gleiche Richtung der Flächennormalen und damit die gleiche oder annähernd gleiche Orientierung aufweisen wie die zweiten steilen Längswände (21) der zweiten vertieften linien- oder bandförmigen Strukturen (16), **dadurch gekennzeichnet, dass** sich zumindest auf einigen oder allen ersten Längswänden (18) der ersten vertieften linien- oder bandförmigen Strukturen (15) erste elektrische Kontakte (22, 26) zum Sammeln und Ableiten eines Ladungsträgertyps (z. B. der Minoritätsladungsträger) und zumindest auf einigen oder allen ersten Längswänden (19) der zweiten vertieften linien- oder bandförmigen Strukturen (16) zweite elektrische Kontakte (23, 24) zum Sammeln und Ableiten des anderen Ladungsträgertyps (z. B. der Majoritätsladungsträger) befinden.

13. Solarzelle nach Anspruch 12, **dadurch gekennzeichnet, dass** sich unter den zweiten Kontakten teilweise eine Oberflächenschicht (25) befindet, welche das Eindiffundieren von Fremdstoffen verhindert, und dass sich diese Oberflächenschicht (25) teilweise auch über das Kontaktgebiet (28) hinaus erstreckt.

14. Solarzelle nach zumindest einem der Ansprüche 12 und 13, **dadurch gekennzeichnet, dass** sich auf der Oberfläche des Halbleitersubstrats eine Passivierschicht oder ein Passivierschichtsystem befindet.

15. Solarzelle nach Anspruch 14, **dadurch gekennzeichnet, dass** die Passivierschicht (27) teilweise unterhalb der ersten und zweiten Kontakte (26) verläuft.

16. Solarzelle nach zumindest einem der Ansprüche 12, 13, 14 und 15, bei der die rückseitigen ersten linien- oder bandförmigen Vertiefungen (29) gegenüber den zweiten linien- oder bandförmigen Vertiefungen (30) in deren Längsrichtung um einigen Abstand seitlich versetzt angeordnet sind.

17. Solarzelle nach Anspruch 16, **dadurch gekennzeichnet, dass** die ersten elektrischen Kontakte, welche sich an den ersten oder zweiten Wänden der ersten oder zweiten linien- oder bandförmigen Vertiefungen (29, 30) befinden, in der Region (31), wo die ersten linien- oder bandförmigen Vertiefungen (29) durch den seitlichen Versatz über die zweiten linien- oder bandförmigen Vertiefungen (30) hinausragen, mittels eines geeigneten elektrisch leitfähigen Materials elektrisch miteinander verbunden sind, und die zweiten elektrischen Kontakte, welche sich an den ersten oder zweiten Wänden der zweiten oder ersten linien- oder bandförmigen Vertiefungen befinden, in der Region (32), wo die zweiten linien- oder bandförmigen Vertiefungen durch den seitlichen Versatz über die ersten linien- oder bandförmigen Vertiefungen hinausragen, mittels eines geeigneten elektrisch leitfähigen Materials elektrisch miteinander verbunden sind.

18. Solarzelle nach zumindest einem der vorgenannten Ansprüche, **dadurch gekennzeichnet, dass** die Vorderseite die gleiche Ausführungsform von ineinander greifenden Kontaktstrukturen wie die Rückseite aufweist.

## Claims

1. Method for producing a solar cell (10) comprising a semiconductor substrate (11) in which minority and majority charge carriers are generated by incident radiation energy and which on the rear side comprises first and second recessed linear or strip-shaped structures (15, 16) with respective first and second steep longitudinal walls (18, 19, 20, 21), wherein the first longitudinal walls (18) of the first linear or strip-shaped recesses (15) have a similar or identical direction of the normal and hence a similar or identical orientation to that of the first longitudinal walls (19) of the second linear or strip-shaped recesses (16) and the second longitudinal walls (20) of the first linear or strip-shaped recesses have a similar or identical direction of the normal and hence have a similar or identical orientation to that of the second longitudinal walls (21) of the second linear or strip-shaped recesses (16) **characterised in that** first electrical contacts (22, 26) for collecting and diverting one charge carrier type (that is, for example, the minority charge carriers) are applied to at least some or all of the first longitudinal walls (18) of the first recessed linear or strip-shaped structures (15) and simultaneously second electrical contacts (23, 24) for collecting and diverting the other charge carrier type (that is, for example, the majority charge carriers) are applied to at least some or all of the first longitudinal walls (19) of the second recessed linear or strip-shaped structures (16) and that no contacts are applied to the respective second longitudinal walls (20, 21) of the first and second recessed linear or strip-shaped structures (15, 16).

2. Method according to claim 1, **characterised in that** the first and the second linear or strip-shaped recesses are generated by means of a method to remove the semiconductor material in which the regions of the semiconductor substrate which are not to be removed are protected using a surface layer which is resistant to the method for removing the semiconductor material.

3. Method according to claim 1 or 2, **characterised in that** the first and second contacts are applied simultaneously by the vapour deposition of material under an angle α to the plane spanned by the semiconductor substrate, wherein the vapour deposition angle α is α ≠ 0° and α ≠ 90°.

4. Method according to at least one of the preceding claims, **characterised in that** the rear side of the semiconductor substrate is provided at least partially or wholly with a surface layer which prevents the diffusion of foreign matter.

5. Method according to claim 4, **characterised in that** the surface layer which prevents the diffusion of foreign matter is itself a source of foreign matter which is suitable for doping the semiconductor substrate.

6. Method according to claim 4 or 5, **characterised in that** the surface layer which prevents the diffusion of foreign matter is heated locally by suitable processes, eg laser radiation, so that its physical and/or chemical properties change compared to the non-heated regions.

7. Method according to at least one of claims 4, 5 and 6, **characterised in that** the first or second electrical contacts extend completely on the surface layer which prevents the diffusion of foreign matter and that these first or second electrical contacts penetrate this surface layer due to local heating, eg by laser radiation.

8. Method according to at least one the preceding claims, **characterised in that**, prior to or after the application of the first and second electrical contacts, the uncovered surfaces of the semiconductor substrate and all other exposed surfaces are provided over the whole area or to a large extent over the whole area with a layer or a layer system which is suitable for the electronic blooming of the semiconductor surface.

9. Method according to claim 8 **characterised in that** the passivating surface layer is produced prior to the application of the first and second electrical contacts and at the place where the second or first electrical contact is to be applied is removed again completely or at least partially by means of a suitable method, eg laser radiation.

10. Method according to at least one the above claims, **characterised in that** the first linear or strip-shaped recesses are arranged at distance laterally offset with respect to the second linear or strip-shaped recesses in the longitudinal direction thereof.

11. Method according to claim 10, **characterised in that** the first electrical contacts which are located on the first or second walls of the first linear or strip-shaped recesses are connected to each other by means of a suitable electrically conductive material in the region where the first linear or strip-shaped recesses protrude over the second linear or strip-shaped recesses due to the lateral offset and the second electrical contacts which are located on the first or second walls of the second linear or strip-shaped recesses are connected to each other by means of a suitable electrically conductive material in the region where the second linear or strip-shaped recesses protrude over the first linear or strip-shaped recesses due to the lateral offset.

12. Solar cell (10) comprising a semiconductor substrate (11), in which minority and majority charge carriers are generated by incident radiation energy and which on the rear side comprises first and second recessed linear or strip-shaped structures (15, 16) with respective first and second steep longitudinal walls (18, 19, 20, 21), wherein the first steep longitudinal walls (18) of the first recessed linear or strip-shaped structures (15) have an identical or approximately identical direction of the normal and hence an identical or approximately identical orientation to that of the first steep longitudinal walls (19) of the second recessed linear or strip-shaped structures (16) and the second steep longitudinal walls (20) of the first recessed linear or strip-shaped structures (15) have an identical or approximately identical direction of the normal and hence an identical or approximately identical orientation to that of the second steep longitudinal walls (21) of the second recessed linear or strip-shaped structures (16), **characterised in that** first electrical contacts (22, 26) for collecting and diverting one charge carrier type (that is, for example, the minority charge carriers) are applied to at least some or all of the first longitudinal walls (18) of the first recessed linear or strip-shaped structures (15) and second electrical contacts (23, 24) for collecting and diverting the other charge carrier type (for example the majority charge carriers) are applied to at least some or all of the first longitudinal walls (19) of the second recessed linear or strip-shaped structures (16).

13. Solar cell according to claim 12, **characterised in that** under the second contacts there is partially a surface layer (25) which prevents the diffusion of foreign matter and that this surface layer 430 (25) partially also extends beyond the contact region (28).

14. Solar cell according to at least one the claims 12 and 13, **characterised in that** there is a passivating layer or a passivating layer system on the surface of the semiconductor substrate.

15. Solar cell according to claim 14, **characterised in that** the passivating layer (27) extends partially below the first and second contacts (26).

16. Solar cell according to at least one the claims 12, 13, 14 and 15, in which the rear-side first linear or strip-shaped recesses (29) are arranged at distance laterally offset with respect to the second linear or strip-shaped recesses (30) in the longitudinal direction thereof.

17. Solar cell according to claim 16, **characterised in that** the first electrical contacts which are located on the first or second walls of the first or second linear or strip-shaped recesses (29, 30) are connected to each other by means of a suitable electrically conductive material in the region (31) where the first linear or strip-shaped recesses protrude over the second linear or strip-shaped recesses (30) due to the lateral offset and the second electrical contacts, which are located on the first or second walls of the second linear or strip-shaped recesses, are connected to each other by means of a suitable electrically conductive material in the region (32) where the second linear or strip-shaped recesses protrude over the first linear or strip-shaped recesses due to the lateral offset.

18. Solar cell according to at least one the preceding claim, **characterised in that** the front side comprises an arrangement with intermeshing contact structures which is identical to that of the rear side.

## Revendications

1. Procédé de fabrication d'une cellule solaire (10) comprenant un substrat semi-conducteur (11), dans lequel sont générés des porteurs de charge minoritaires et majoritaires par énergie rayonnante incidente et qui présente en face arrière des premières et des secondes structures (15, 16) creusées en forme de ligne ou de bande avec chacune des premières et des deuxièmes parois longitudinales (18, 19, 20, 21) à forte pente, les premières parois longitudinales (18) des premiers creux (15) en forme de ligne ou de bande présentant une direction de la normale surfacique analogue ou égale et ainsi une orientation analogue ou égale à celle des premières parois longitudinales (19) des seconds creux (16) en forme de ligne ou de bande, et les deuxièmes parois longitudinales (20) des premiers creux (15) en forme de ligne ou de bande présentant une direction de la normale surfacique analogue ou égale et ainsi une orientation analogue ou égale à celle des deuxièmes parois longitudinales (21) des seconds creux (16) en forme de ligne ou de bande, **caractérisé en ce que** des premiers contacts électriques (22, 26) pour collecter et dériver un type de porteur de charge (donc par exemple le porteur de charge minoritaire) sont appliqués au moins sur quelques-unes ou sur toutes les premières parois longitudinales (18) des premières structures (15) creusées en forme de ligne ou de bande, et des seconds contacts électriques (23, 24) pour collecter et dériver l'autre type de porteur de charge (donc par exemple le porteur de charge majoritaire) sont simultanément appliqués au moins sur quelques-unes ou sur toutes les premières parois longitudinales (19) des secondes structures (16) creusées en forme de ligne ou de bande, et **en ce qu'**aucun contact n'est appliqué sur les deuxièmes parois longitudinales respectives (20, 21) des premières et des secondes structures (15, 16) creusées en forme de ligne ou de bande.

2. Procédé suivant la revendication 1, **caractérisé en ce que** les premiers et les seconds creux en forme de ligne ou de bande sont produits au moyen d'un procédé d'enlèvement du matériau semi-conducteur, procédé dans lequel les zones du substrat semi-conducteur, qui ne doivent pas être enlevées, sont protégées en utilisant une couche superficielle résistante au procédé d'enlèvement du matériau semi-conducteur.

3. Procédé suivant l'une des revendications 1 et 2, **caractérisé en ce que** les premiers et les seconds contacts sont appliqués simultanément par métallisation sous vide de matériau sous un angle α par rapport au plan fixé par le substrat semi-conducteur, l'angle de métallisation sous vide α étant tel que α≠0° et α≠90°.

4. Procédé suivant l'une au moins des revendications précédentes, **caractérisé en ce que** la face arrière du substrat semi-conducteur est munie au moins en partie ou en totalité d'une couche superficielle, qui empêche la diffusion d'impuretés.

5. Procédé suivant la revendication 4, **caractérisé en ce que** la couche superficielle, qui empêche la diffusion d'impuretés, est elle-même source d'une impureté adaptée au dopage du substrat semi-conducteur.

6. Procédé suivant l'une des revendications 4 et 5, **caractérisé en ce que** la couche superficielle, qui empêche la diffusion d'impuretés, est chauffée localement par des processus appropriés, par exemple par rayonnement laser, de sorte que ses propriétés physiques et/ou chimiques se modifient par rapport aux zones non chauffées.

7. Procédé suivant l'une au moins des revendications 4, 5 et 6, **caractérisé en ce que** les premiers ou seconds contacts électriques s'étendent totalement sur la couche superficielle, qui empêche la diffusion d'impuretés, et que ces premiers ou seconds contacts électriques pénètrent au travers de cette couche superficielle par chauffage local, par exemple par rayonnement laser.

8. Procédé suivant l'une au moins des revendications précédentes, **caractérisé en ce que**, avant ou après l'application des premiers et seconds contacts électriques, les surfaces dégagées du substrat semi-conducteur et toutes les autres faces exposées sont munies sur toute leur surface ou largement sur toute leur surface d'un couche ou d'un système de couches adaptés à traiter par voie électronique la surface du semi-conducteur.

9. Procédé suivant la revendication 8, **caractérisé en ce que** la couche superficielle passivante est réalisée avant l'application des premiers et des seconds contacts électriques et de nouveau éliminée à l'endroit où le second ou le premier contact électrique doit être appliqué, totalement ou au moins en partie au moyen d'un procédé adéquat, par exemple rayonnement laser.

10. Procédé suivant l'une au moins des revendications précitées, **caractérisé en ce que** les premiers creux en forme de ligne ou de bande sont disposés en déport latéral d'une certaine distance dans leur direction longitudinale par rapport aux seconds creux en forme de ligne ou de bande.

11. Procédé suivant la revendication 10, **caractérisé en ce que** les premiers contacts électriques, qui se situent sur les premières ou sur les deuxièmes parois des premiers creux en forme de ligne ou de bande, sont reliés électriquement entre eux au moyen d'un matériau adéquat conducteur électriquement dans la région où les premiers creux en forme de ligne ou de bande dépassent par le déport latéral des seconds creux en forme de ligne ou de bande, et les seconds contacts électriques, qui se situent sur les premières ou sur les deuxièmes parois des seconds creux en forme de ligne ou de bande, sont reliés électriquement entre eux au moyen d'un matériau adéquat conducteur électriquement dans la région où les seconds creux en forme de ligne ou de bande dépassent par le déport latéral des premiers creux en forme de ligne ou de bande.

12. Cellule solaire (10) comprenant un substrat semi-conducteur (11), dans lequel sont générés des porteurs de charge minoritaires et majoritaires par énergie rayonnante incidente et qui présente en face arrière des premières et des secondes structures (15, 16) creusées en forme de ligne ou de bande avec chacune des premières et des deuxièmes parois longitudinales (18, 19, 20, 21) à forte pente, les premières parois longitudinales (18) à forte pente des premières structures (15) creusées en forme de ligne ou de bande présentant la direction de la normale surfacique égale ou approximativement égale et ainsi une orientation égale ou approximativement égale à celle des premières parois longitudinales (19) à forte pente des secondes structures (16) creusées en forme de ligne ou de bande, et les deuxièmes parois longitudinales (20) à forte pente des premières structures (15) creusées en forme de ligne ou de bande présentant la direction de la normale surfacique égale ou approximativement égale et ainsi l'orientation égale ou approximativement égale à celle des deuxièmes parois longitudinales (21) à forte pente des secondes structures (16) creusées en forme de ligne ou de bande, **caractérisée en ce que** des premiers contacts électriques (22, 26) pour collecter et dériver un type de porteur de charge (par exemple le porteur de charge minoritaire) se situent au moins sur quelques-unes ou sur toutes les premières parois longitudinales (18) des premières structures (15) creusées en forme de ligne ou de bande, et des seconds contacts électriques (23, 24) pour collecter et dériver l'autre type de porteur de charge (par exemple le porteur de charge majoritaire) se situent au moins sur quelques-unes ou sur toutes les premières parois longitudinales (19) des secondes structures (16) creusées en forme de ligne ou de bande.

13. Cellule solaire suivant la revendication 12, **caractérisée en ce qu'**une couche superficielle (25) se situe en partie au-dessous des seconds contacts, laquelle couche empêche la diffusion d'impuretés, et que cette couche superficielle (25) s'étend en partie également par-dessus la région de contact (28).

14. Cellule solaire suivant l'une au moins des revendications 12 et 13, **caractérisée en ce qu'**une couche passivante ou un système de couches passivantes se situe sur la surface du substrat semi-conducteur.

15. Cellule solaire suivant la revendication 14, **caractérisée en ce que** la couche passivante (27) s'étend en partie au-dessous des premiers et seconds contacts (26).

16. Cellule solaire suivant l'une au moins des revendications 12, 13, 14 et 15, dans laquelle les premiers creux (29) en face arrière, en forme de ligne ou de bande, sont disposés en déport latéral d'une certaine distance dans leur direction longitudinale par rapport aux seconds creux (30) en forme de ligne ou de bande.

17. Cellule solaire suivant la revendication 16, **caractérisée en ce que** les premiers contacts électriques, qui se situent sur les premières ou sur les deuxièmes parois des premiers ou des seconds creux (29, 30) en forme de ligne ou de bande, sont reliés électriquement entre eux au moyen d'un matériau adéquat conducteur électriquement dans la région (31), où les premiers creux (29) en forme de ligne ou de bande dépassent par le déport latéral des seconds creux (30) en forme de ligne ou de bande, et les seconds contacts électriques, qui se situent sur les premières ou sur les deuxièmes parois des seconds ou des premiers creux en forme de ligne ou de bande, sont reliés électriquement entre eux au moyen d'un matériau adéquat conducteur électriquement dans la région (32), où les seconds creux en forme de ligne ou de bande dépassent par le déport latéral des premiers creux en forme de ligne ou de bande.

18. Cellule solaire suivant l'une au moins des revendications précitées, **caractérisée en ce que** la face avant présente le même mode de réalisation de structures de contact s'engageant les unes dans les autres que la face arrière.
